# EUROPÄISCHE PATENTSCHRIFT

(11) **EP 2 376 667 B1**
(45) Veröffentlichungstag und Bekanntmachung des Hinweises auf die Patenterteilung: **16.03.2016**
(21) Anmeldenummer: 09795701.3
(22) Anmeldetag: 12.12.2009
(51) Int. Cl.: C23C 14/04, C23C 14/50

(54) **VERFAHREN ZUR FUNKTIONSFLÄCHENBESCHICHTUNG**
METHOD FOR COATING FUNCTIONAL SURFACES
PROCÉDÉ DE REVÊTEMENT DE SURFACES FONCTIONNELLES

(30) Priorität: 09.01.2009 DE 102009004158
(43) Veröffentlichungstag der Anmeldung: 19.10.2011
(73) Patentinhaber: Bayerische Motoren Werke Aktiengesellschaft, 80809 München (DE); Fraunhofer-Gesellschaft zur Förderung der angewandten Forschung e.V., 80686 München (DE)
(72) Erfinder: SCHNAGL, Johann, 82256 Fürstenfeldbruck (DE); KURSAWE, Serge, 91080 Uttenreuth (DE); SCHEIBE, Hans-Joachim, 01309 Dresden (DE); WEIHNACHT, Volker, 01309 Dresden (DE)
(74) Vertreter: Pfenning, Meinig & Partner mbB
(86) Internationale Anmeldenummer: PCT/EP2009/008914
(87) Internationale Veröffentlichungsnummer: WO 2010/078914

(56) Entgegenhaltungen:
- WO-A2-95/12693
- JP-A- 5 051 740
- JP-A- 56 020 162
- JP-A- 56 111 804
- JP-A- 59 139 930
- JP-A- 63 137 161
- JP-A- H04 214 854

## Beschreibung

Die Erfindung bezieht sich auf ein Verfahren zur Beschichtung der Funktionsflächen von symmetrisch gezackten Bauteilen, insbesondere der Zahnflanken von Zahnrädern, mit einer relativ zum Bauteil umlaufenden, das Beschichtungsmaterial in Form von elektrisch geladenen Partikeln in Richtung des Bauteils emittierenden Beschichtungsquelle, nach dem Oberbegriff des Patentanspruchs 1.

Es ist bekannt, die Zahnflanken von Zahnrädern zur Verbesserung der Laufeigenschaften im Wege einer Gasphasenabscheidung in der Weise zu beschichten, dass ein Plasma, erzeugt von einer Beschichtungsquelle etwa auf Graphitbasis und beschleunigt in einem elektrischen oder magnetischen Feld, mit hoher Geschwindigkeit auf die Zahnflanken emittiert wird und sich dort in den randnahen Zahnflankenbereichen einlagert, wo sich die graphitischen Plasmateilchen in eine extrem harte, diamantartige Beschichtung umwandeln. Entscheidend für die Beschichtungsquafität ist dabei neben dem lonisationsgrad und der Energie der Plasmateilchen auch deren Auftreffwinkel auf der Bauteiloberfläche. Während der Umlaufbewegung jedoch ändert sich die Ausrichtung der Zahnflanken gegenüber der Bestrahlungsrichtung und mit zunehmend kleinerem Auftreffwinkel verringert sich die Eindringtiefe der Plasmateilchen in die Oberfläche, mit der Folge, dass die Schichtqualität auf den Zahnflanken nicht ausreicht, eine dauerhaft hochwertige Zahnflankenbeschichtung sicherzustellen.

So ist aus JP 59 139930 A eine Vakuumbeschichtungsvorrichtung bekannt, bei der ein zylindrisches Substrat beschichtet werden soll. Dabei soll das Substrat drehbar angeordnet sein.

Die DE 10 2007 051 023 A1 betrifft ein verfahren zum Beschichten einer Oberfläche eines Bauteils, bei dem statisch geladene Partikel aus Beschichtungsmaterial erzeugt und in Richtung des zu beschichtenden Bauteils bewegt werden.

In JP 56 111804 A sind Möglichkeiten zur Beschichtung von Oberflächen mit unterschiedlicher Ausrichtung zueinander beschrieben.

Die JP 63 137161 A betrifft Möglichkeiten für die Ausbildung von Schichten auf einer Welle unter Vakuumbedingungen unter Einsatz von Laserstrahlung, die auf einen Beschichtungswerkstoff gerichtet wird.

Aus JP 50 51740 A ist eine Vorrichtung zur Ausbildung dünner Schichten auf Substraten mit komplexer Oberfläche beschirieben.

Demgegenüber ist es Aufgabe der Erfindung, das Verfahren der eingangs genannten Art so auszubilden, dass auf einfache Weise eine qualitativ hochwertige Funktionsflächenbeschichtung des Bauteils und insbesondere der Zahnflanken eines Zahnrads erzielt wird.

Außerdem sind aus JP H04 214854 A Möglichkeiten für die Beschichtung von Zahnflanken von Zahnrädern mit BN unter Einsatz einer Maske bekannt.

Diese Aufgabe wird erfindungsgemäß durch das im Patentanspruch 1 gekennzeichnete Verfahren gelöst.

Erfindungsgemäß wird durch eine konstruktiv einfache Abschattung des Bauteils der kritische Umlaufbereich, in welchem die Funktionsflächen des Bauteils unter einem flachen Winkel zur Bestrahlungsrichtung angestellt sind, ausgeblendet und dadurch eine einfallbedingt unzureichende Schichthaftung und -qualität wirksam unterbunden. Das Ergebnis ist eine integral mit dem Bauteil verbundene Beschichtung mit hervorragenden tribolischen Eigenschaften, wie sie insbesondere von hochbelasteten Zahnrädern, etwa in Kraftfahrzeuggetrieben, gefordert werden.

Bei der Erfindung werden das Bauteil und die Beschichtungsquelle relativ zueinander intermittierend oder ungleichförmig mit längeren Verweilzeiten in der steil zur Bestrahlungsrichtung angestellten Drehposition der Funktionsflächen umlaufend angetrieben, so dass der Hauptteil des Beschichtungsmaterials in einem hinsichtlich Schiehthafturig und -härte optimalen Winkelbereich auf die Funktionsfläche auftrifft.

Im Rahmen der Erfindung lassen sich aus Gründen einer Beschichtungsmaterial- und -Zeitersparnis ohne Weiteres auch die Funktionsflächen auf nur einer Seite der Bauteilzacken, also an Zahnrädern nur die in Laufrichtung stärker belasteten Zahnflanken, auf einfache Weise dadurch beschichten, dass das Bauteil halbseitig über die eine Grenze des Umlaufbereichs hinaus durch die Blende vollständig abgeschattet ist.

Als Beschichtungsmaterial wird, wie an sich bekannt, vorzugsweise ein Ionenoder Plasmastrahl verwendet, welcher im Hinblick auf eine verbesserte Führung zusätzlich mit einem elektrischen und/oder magnetischen Feld abgelenkt wird. Dabei wird das Feld in besonders bevorzugter Weise derart mit der Blende kombiniert, dass der Beschichtungsstrahl derart gebündelt wird, dass ein Teil der sonst von der Blende abgefangenen Beschichtungspartikel unter Erhöhung der Beschichtungsintensität beschichtungswirksam auf der Funktionsfläche abgeschieden und dadurch die Beschichtungsrate signifikant erhöht wird.

In einer besonders bevorzugten Variante der Erfindung lässt sich in dem problematischen Fall einer Kegelradbeschichtung mit spiralförmig verlaufenden Zahnflanken der Flankenbereich, der den einfallenden Beschichtungspartikeln unter einem ausreichend steilen Winkel ausgesetzt ist, auf einfache Weise dadurch deutlich vergrößern, dass die Kegelradachse in einer bezüglich der Bestrahlungsrichtung festen Kipplage schräg geneigt wird.

Die Erfindung wird nunmehr in dem bevorzugten Anwendungsfall einer Zahnrandbeschichtung anhand mehrerer Ausführungsbeispiele in Verbindung mit den Figuren näher erläutert, Es zeigen in stark schematisierter Darstellung
- **Fig. 1a, b**: eine erfindungsgemäße Zahnflankenbeschichtung eines Zahnrads in einer ersten Ausführungsform;
- **Fig. 2**: eine der Fig.1 entsprechende Darstellung einer Zahnradbeschichtung im verkleinerten Maßstab in einer zweiten Ausführungsform der Erfindung;
- **Fig. 3**: ein drittes Ausführungsbeispiel einer Zahnflankenbeschichtung mit einer mit der Blende kombinierten Vorrichtung zur Bündelung des Beschichtungsstrahls; und
- **Fig. 4**: ein weitere Variante der Erfindung zur Zahnflankenbeschichtung eines Kegelrads.

Das in den Fign. gezeigte Beschichtungssystem dient zur Zahnflankenbeschichtung von Zahnrädern 1 und enthält eine Beschichtungsquelle 2, welche einen in den Fign. idealisiert als paralleleisierter Beschichtungsstrahl dargestellten, tatsächlich aber wesentlich diffuseren Beschichtungsstrahl in Form eines ionisierten Plasmastroms in Richtung des Zahnrads 1 emittiert. Die Plasmateilchen werden in einem magnetischen und/oder elektrischen Feld, z. B. durch Anlegen einer elektrischen Spannung an das Zahnrad 1, so stark beschleunigt, dass sie mit hoher kinetischer Energie auf die Zahnflanken 3 auftreffen und dort eine festhaltende, harte Beschichtung ausbilden.

Während des Beschichtungsprozesses wird das Zahnrad 1 um die Zahnradachse gedreht, so dass sämtliche Zahnflanken 3 nacheinander in den Beschichtungsstrahl der Beschichtungequelle 1 gelangen. Dabei ändert sich jedoch die Ausrichtung der Zahnflanken 3 zur Bestrahlungsrichtung und somit auch der Auftreffwinkel der Plamateilchen auf der Zahnflanke 3. In einem Umlaufbereich des Zahnrads 1 mit einer bezüglich der Bestrahlungsrichtung flachen Zahnflankenausriehtung wird der Auftreffwinkel der Plasmateilchen so klein, dass keine ausreichende Schichthaftung und -qualität mehr erzielt wird.

Unter einer flachen Zahnflankenausrichtung ist eine Neigung der Zahnflanken 3 bezüglich der Richtung des einfallenden Plasmastroms zu verstehen, die dazu führt, dass die Plasmateilchen beim Auftreffen auf die Zahnflanken 3 entweder reflektiert werden oder eine Beschichtung ausbilden, die den Qualitätsanforderungen hinsichtlich Schichthaftung und -härte nicht genügt. Dieser kritische Neigungswinkel ist auch abhängig von den restlichen Verfahrensparametern und liegt bei den gezeigten Ausführungsbeispielen im Bereich zwischen etwa 10 und 20".

in diesem Umlaufbereich wird das Zahnrad 1 erfindungsgemäß auf konstruktiv einfache Weise, nämlich durch eine zwischen Zahnrad 1 und Beschichtungsquelle 2 quer zur Bestrahlungsrichtung angeordnete Blende 4 vom Plasmastrom abgeschattet.

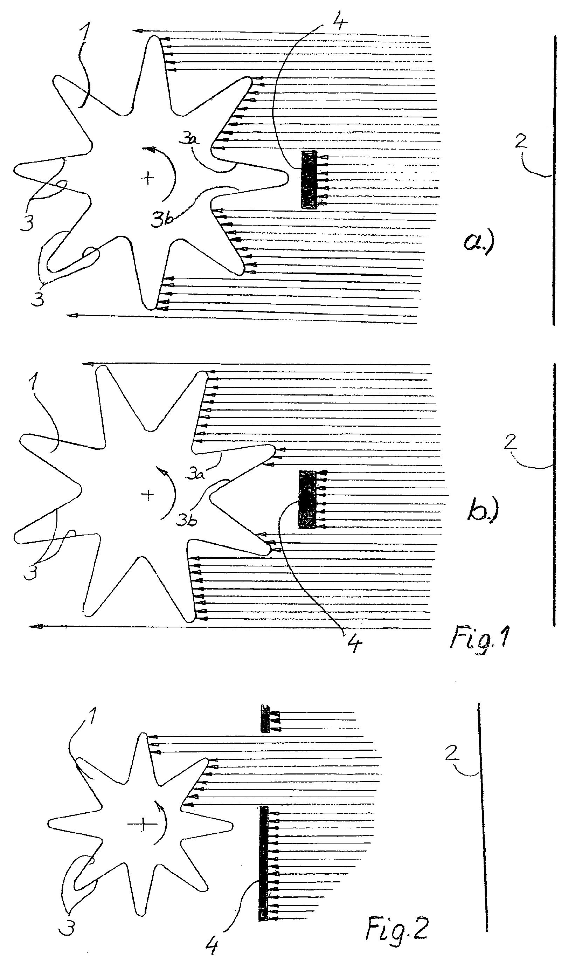

Bei dem Ausführungsbeispiel gemäß Fig. 1 befinden sich die beiden Zahnflanken 3a und 3b in der in Fig. 1a dargestellten Drehlage gerade im kritischen Umlaufbereich mit flach zur Bestrahlungsrichtung geneigter Flächenausrichtung und werden durch die Blende 4 vom Beschichtungsstrahl abgeschirmt. Wenn sich das Zahnrad 1 weiterdreht (Fig. 1b), gelangt die vordere Zahnflanke 3a in eine durch den Zahnkopf abgeschattet Drehposition, während die in Drehrichtung hintere Zahnflanke 3b in den Durchlassbereich der Blende 4 läuft und nunmehr mit einem ausreichend großen Neigungswinkel zur Bestrahlungsriehtung ausgerichtet ist. Bei der weiteren Drehung des Zahnrads 1 wird der Auftreffwinkel des Plasmastroms auf der Zahnflanke 3b zunehmend steiler und erreicht den beschichtungsoptimalen Auftreffwinkelbereich bis hin zu 90°. In diesem Bereich wird die Drehbewegung des Zahnrads 1 verlangsamt oder angehalten und dadurch sichergestellt, dass der Hauptteil des Beschichtungsmaterials beschichtungsoptimal abgeschieden wird. Auf diese Weise werden beim Umlauf des Zahnrads 1 nacheinander sämtliche Zahnflanken 3 beschichtet.

Das in Fig. 2 gezeigte Beschichtungssystem, bei dem die dem ersten Ausführungsbeispiel entsprechenden Komponenten durch das gleiche Bezugszeichen gekennzeichnet sind, unterscheidet sich von diesem hauptsächlich dadurch, dass die Blende 4 einseitig verlängert ist, so dass sie die eine Zahnradhälfte vollständig abschattet. Hierdurch wird eine einseitige Zahnflankenbeschichtung erreicht, wie dies für Zahnräder, die im Betriebszustand vorwiegend oder ausschließlich nur an ein und derselben Zahnflanke jedes Flankenpaares belastet sind, bevorzugt wird.

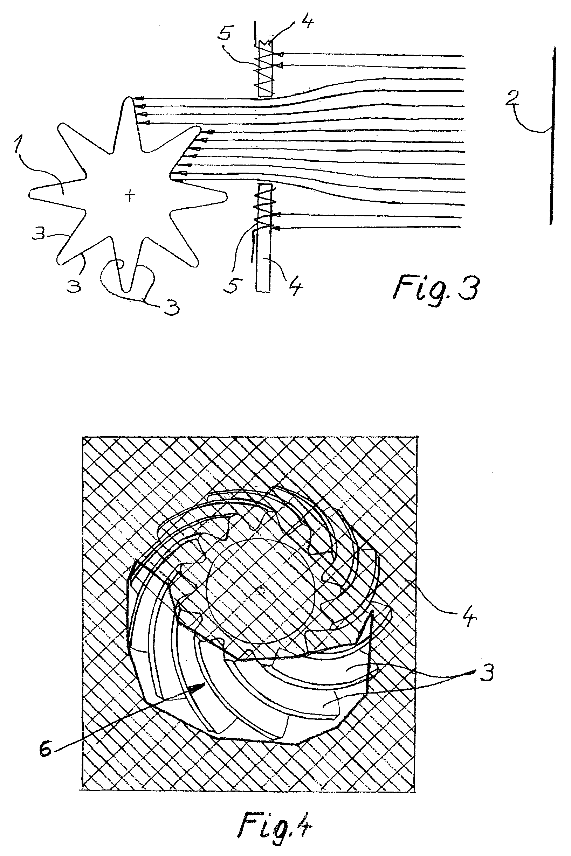

Bei dem in Fig. 3 dargestellten Ausführungsbeispiel ist die Blende 4 mit einer elektrischen oder magnetischen Feldführung 5 kombiniert, die eine Bündelung des Plasmastrahls bewirkt, derart, dass ein Teil des Plasmastrahls, der sonst von der Blende 4 abgefangen werden würde, unter Verengung des Beschichtungsstrahlquerschnitts auf dem Wege über den Blendendurchlass ebenfalls beschichtungswirksam abgeschieden wird, wodurch sich die Beschichtungsintensität des einfallenden Plasmastroms und dementsprechend auch die zeitliche Beschichtungsrate signifikant erhöhen.

Fig. 4 veranschaulicht die Plasmabeschichtung eines Kegelrads 6 mit spiralförmig verlaufenden Zahnflanken 3. In diesem Fall wird allein durch ein Verkippen der Kegelradachse aus der zur Bestrahlungsrichtung senkrechten in eine hierzu geneigte Schräglage mit dem verjüngten Kegelradende in Richtung der Beschichtungsquelle der Flächenanteil der Zahnflanken 3, aufweichen die Plasmateilchen unter einem ausreichend großen Einfallwinkel auf die Zahlflanken 3 auftreffen, deutlich vergrößert, während die übrigen Flankenbereiche mit einer flachen Flächenausrichtung durch die in Fig. 4 kreuzschraffiert dargestellte Blende 4 abgeschattet werden. In der Perspektive der Fig. 4 befindet sich die Beschichtungsquelle oberhalb der Zeichenebene und ist nicht dargestellt und die Bestrahlungsrichtung ist gegenüber der Blickrichtung geringfügig geneigt. Im Rahmen der Erfindung lassen sich natürlich auch die Funktionsflächen von anderen, zentralsymmetrisch gezackten Bauteilen, etwa Bohrern oder Fräsern, in analoger Weise beschichten.

## Patentansprüche

1. Verfahren zur Beschichtung der Funktionsflächen von symmetrisch gezackten Bauteilen, insbesondere der Zahnflanken von Zahnrädern, mittels einer das Beschichtungsmaterial in Form von elektrisch geladenen Partikeln in Richtung des Bauteils emittierenden, relativ zu diesem umlaufenden Beschichtungsquelle, wobei das Bauteil während des Beschichtungsprozesses in einem Umlaufbereich mit flach zur Bestrahlungsrichtung geneigter Funktionsflächenausrichtung durch eine zwischen Bauteil und Beschichtungsquelle quer zur Bestrahlungsrichtung angeordnete Blende vom Beschichtungsstrahl abgeschirmt wird,
*dadurch gekenntzeichnet, das*
das Bauteil und die Beschichtungsquelle relativ zueinander um die Bautellachse ungleichförmig mit längeren Verweilzeiten in der steil zur Bestrahlungsrichtung angestellten Drehposition der Funktionsflächen gedreht werden.

2. Verfahren nach Anspruch 1,
***dadurch gekennzeichnet, dass***
für eine einseitige Funktionsflächenbeschichtung des Bauteils dieses halbseitig über die eine Grenze des Umlaufbereichs hinaus durch die Blende vollständig abgeschattet wird.

3. Verfahren nach einem der vorhergehenden Ansprüche,
***dadurch gekennzeichnet dass***
die Beschichtung mit einem Ionen-oder Plasmastrahl durchgeführt wird.

4. Verfahren nach einem der vorhergehenden Ansprüche,
***dadurch gekennzeichnet, dass***
der Beschichtungsstrahl zusätzlich mit einem magnetischen und/oder elektrischen Feld abgelenkt wird.

5. Verfahren nach Anspruch 4,
*dadurch gekennzeichet, dass*
der Beschichtungsstrahl mit dem magnetischen und/oder elektrischen Feld gebündelt wird.

6. Verfahren nach einem der vorhergehenden Ansprüche zur Zahnflankenbeschichtung von Kegelrädern,
***dadurch gekennzeichnet, dass***
das Kegelrad beim Beschichtungsprozess um die Kegelradachse gedreht und diese in Richtung der Beschichtungsquel-le schräg angestellt wird.

## Claims

1. Method for coating functional surfaces of symmetrically serrated components, in particular tooth flanks of gears, via a coating source emitting the coating material as electrically charged particles in an irradiation direction of the component and rotating relatively to the component, wherein
the component is shielded during the coating process in a contour area of the component from the coating beam, the contour area having a functional surface orientation that is inclined flatly with respect to the irradiation direction using a shield arranged transversely to the irradiation direction between the component and the coating source, **characterized in that**
the component and the coating source are rotated relatively to each other about an axis of the component which is non-uniform with longer dwell times occurring in a rotational position of the functional surface set steeply with respect to the irradiation direction.

2. Method according to claim 1, **characterized in that** the component is shielded completely by the shield in a half-sided manner beyond one boundary of the contour area of the component for a one-sided functional surface coating of the component.

3. Method according to one of the preceding claims, **characterized in that** the coating is performed by an ion or plasma current.

4. Method according to one of the preceding claims, **characterized in that** the coating beam is deflected additionally via a magnetic and/or electric field.

5. Method according to claim 4, **characterized in that** the coating beam is focused via the magnetic and/or electric field.

6. Method according to one of the preceding claims for tooth flank coating of bevel gears, **characterized in that** the bevel gear is rotated about the bevel gear axis during the coating process and the bevel gear axis is tilted in a direction of the coating source.

## Revendications

1. Procédé de revêtement des surfaces fonctionnelles d'éléments de construction symétriquement dentelés, en particulier des flancs de dents de roues dentées, au moyen d'une source de revêtement émettant le matériau de revêtement sous la forme de particules électriquement chargées en direction de l'élément de construction, et circulant autour de celui-ci, dans lequel, pendant le processus de revêtement, dans une zone de rotation avec une orientation de surfaces fonctionnelles inclinée à plat par rapport à la direction du jet, l'élément de construction est protégé du jet revêtement par un écran disposé entre l'élément de construction et la source de revêtement transversalement à la direction du jet
***caractérisé en ce que***
l'élément de construction et la source de revêtement sont tournés l'un par rapport à l'autre autour de l'axe de l'élément de construction de façon irrégulière avec des temps de séjour plus longs dans la position de rotation des surfaces fonctionnelles placée à pic par rapport à la direction de rayonnement

2. Procédé selon la revendication 1,
***caractérisé en ce que**,*
pour un revêtement unilatéral de surfaces fonctionnelles de l'élément de construction, cet élément est recouvert complètement par l'écran d'un côté au-delà d'une limite de la zone de rotation.

3. Procédé selon l'une des revendications précédentes,
***caractérisé en ce que**,*
le revêtement est effectué avec un faisceau ionique ou un jet de plasma.

4. Procédé selon l'une des revendications précédentes,
***caractérisé en ce que**,*
le jet de revêtement est en plus dévié avec un champ magnétique et/ou électrique.

5. Procédé selon la revendication 4,
***caractérisé en ce que**,*
le jet de revêtement est focalisé avec le champ magnétique et/ou électrique.

6. Procédé selon l'une des revendications précédentes pour le revêtement de flancs de dents de roues coniques,
***caractérisé en ce que**,*
lors du processus de revêtement, la roue conique est tournée autour de l'axe de roue conique et cet axe est placé obliquement en direction de la source de revêtement.
